# EUROPÄISCHE PATENTSCHRIFT

(11) **EP 3 414 368 B1**
(45) Veröffentlichungstag und Bekanntmachung des Hinweises auf die Patenterteilung: **22.09.2021**
(21) Anmeldenummer: 17706425.0
(22) Anmeldetag: 10.02.2017
(51) Int. Cl.: C30B 29/40, G01J 3/20, H01L 21/02, H01L 31/0304

(54) **TERAHERTZ-ANTENNE UND VERFAHREN ZUM HERSTELLEN EINER TERAHERTZ-ANTENNE**
TERAHERTZ ANTENNA AND METHOD FOR PRODUCING A TERAHERTZ ANTENNA
ANTENNE TÉRAHERTZ ET PROCÉDÉ POUR LA FABRICATION D'UNE ANTENNE TÉRAHERTZ

(30) Priorität: 12.02.2016 DE 102016202216
(43) Veröffentlichungstag der Anmeldung: 19.12.2018
(73) Patentinhaber: Fraunhofer-Gesellschaft zur Förderung der angewandten Forschung e.V., 80686 München (DE)
(72) Erfinder: DIETZ, Roman, 10437 Berlin (DE); GÖBEL, Thorsten, 10587 Berlin (DE); GLOBISCH, Björn, 13347 Berlin (DE); MASSELINK, William Ted, 12205 Berlin (DE); SEMTSIV, Mykhaylo Petrovych, 10318 Berlin (DE)
(74) Vertreter: Maikowski & Ninnemann Patentanwälte Partnerschaft mbB
(86) Internationale Anmeldenummer: PCT/EP2017/053053
(87) Internationale Veröffentlichungsnummer: WO 2017/137589

(56) Entgegenhaltungen:
- US-A1- 2012 113 417
- SALAUN S ET AL: "Semi-insulating InP:Fe by GSMBE: Optimal growth conditions", INDIUM PHOSPHIDE AND RELATED MATERIALS, 1993. CONFERENCE PROCEEDINGS., FIFTH INTERNATIONAL CONFERENCE ON PARIS, FRANCE 19-22 APRIL 1993, NEW YORK, NY, USA,IEEE, 19. April 1993 (1993-04-19), Seiten 147-150, XP010130294, DOI: 10.1109/ICIPRM.1993.380688 ISBN: 978-0-7803-0993-7
- GICQUEL-GUÉZO M ET AL: "290fs switching time of Fe-doped quantum well saturable absorbers in a microcavity in 1.55[mu]m range", APPLIED PHYSICS LETTERS, A I P PUBLISHING LLC, US, Bd. 85, Nr. 24, 1. Januar 2004 (2004-01-01), Seiten 5926-5928, XP012063812, ISSN: 0003-6951, DOI: 10.1063/1.1804239
- GUÉZO M ET AL: "Ultrashort, nonlinear, optical time response of Fe-doped InGaAs/InP multiple quantum wells in 1.55-[mu]m range", APPLIED PHYSICS LETTERS, A I P PUBLISHING LLC, US, Bd. 82, Nr. 11, 17. März 2003 (2003-03-17) , Seiten 1670-1672, XP012033512, ISSN: 0003-6951, DOI: 10.1063/1.1557333
- GUÉZO M ET AL: "Nonlinear absorption temporal dynamics of Fe-doped GaInAs/InP multiple quantum wells", JOURNAL OF APPLIED PHYSICS, AMERICAN INSTITUTE OF PHYSICS, US, Bd. 94, Nr. 4, 15. August 2003 (2003-08-15), Seiten 2355-2359, XP012059962, ISSN: 0021-8979, DOI: 10.1063/1.1591077

## Beschreibung

Die Erfindung betrifft eine Terahertz-Antenne gemäß dem Oberbegriff des Anspruchs 1 sowie ein Verfahren zum Herstellen einer Terahertz-Antenne gemäß dem Oberbegriff des Anspruchs 12.

Bekannte Terahertz-Antennen weisen mindestens eine fotoleitende Halbleiterschicht auf, die elektrisch mit Antennenelementen (z.B. Antennenflügeln) für Frequenzen im Terahertz-Bereich (d.h. für Frequenzen im Bereich von 0,1 - 10 THz) kontaktiert sind. Die fotoleitende Halbleiterschicht derartiger Terahertz-Antennen wird zwischen den Antennenelementen mit moduliertem Licht, insbesondere in Form von optischen Pulsen (z.B. mit einer Pulslänge im Bereich von 100 fs) oder einer hochfrequent modulierten Strahlung, beleuchtet. Das eingestrahlte Licht erzeugt in dem Fotoleiter freie Ladungsträger, wobei durch Anlegen einer Spannung an die Antennenelemente die moduliert erzeugten Ladungsträger beschleunigt werden. Die beschleunigten Ladungsträger erzeugen elektromagnetische Strahlung mit der Modulationsfrequenz, d.h. die Terahertz-Antenne wird als Terahertz-Sender betrieben.

Bei einem Betrieb der Terahertz-Antenne als Terahertz-Empfänger induziert eine auf die fotoleitende Halbleiterschicht auftreffende Terahertz-Welle eine Spannung zwischen den Antennenelementen. Diese Spannung ruft im Halbleiter einen Fotostrom hervor, wenn die modulierte Beleuchtung der fotoleitenden Halbleiterschicht synchron zur induzierten Spannung erfolgt. Durch Messung eines mittleren Fotostroms in Abhängigkeit von der relativen Phasenlage der Terahertz-Strahlung und der Beleuchtungsmodulation kann sowohl die Amplitude als auch die Phase der Terahertz-Strahlung detektiert werden (kohärente Detektion).

Die fotoleitende Schicht muss aus einem Material bestehen, das u.a. eine ultraschnelle Rekombination der erzeugten Ladungsträger (z.B. mit Rekombinationszeiten von weniger als einer Pikosekunde) ermöglicht, damit der erzeugte Fotostrom der modulierten Beleuchtung zumindest annähernd folgen kann. Des Weiteren sollte das Material der fotoleitenden Schicht eine möglichst hohe Beweglichkeit der Fotoladungsträger aufweisen, um eine möglichst effiziente Beschleunigung der Ladungsträger zu ermöglichen. Eine Möglichkeit, möglichst kurze Rekombinationszeiten zu erzielen, ist die Erzeugung von Störzentren durch Dotierung des Fotoleitermaterials. Beispielsweise wird gemäß der US 8 809 092 B2 die fotoleitende Schicht per MOVPE gewachsen, wobei während der Epitaxie ein Dotiermaterial (Eisen) eingebracht wird. Bei höheren Dotierstoffkonzentrationen entstehen bei diesem Verfahren jedoch Eisencluster, die die Terahertzeigenschaften der fotoleitenden Schicht beeinträchtigen.

Möglichkeiten zur Herstellung von hochdotierten Schichten per Molekularstrahlepitaxie (MBE) bei Temperaturen zwischen 200°C und 500°C sind in den folgenden Veröffentlichungen beschrieben:
- SALAUN S ET AL: "Semi-insulating InP:Fe by GSMBE: Optimal growth conditions", INDIUM PHOSPHIDE AND RELATED MATERIALS, 1993. CONFERENCE PROCEED-INGS, FIFTH INTERNATIONAL CONFERENCE ON PARIS, FRANCE 19-22 APRIL 1993;
- GICQUEL-GUEZO M ET AL: "290fs switching time of Fe-doped quantum well saturable absorbers in a microcavity in 1.55µm range", APPLIED PHYSICS LETTERS, A I P PUB-LISHING LLC, US, Bd. 85, Nr. 24, 1. Januar 2004;
- GUEZO M ET AL: "Ultrashort, nonlinear, optical time response of Fe-doped InGaAs/InP multiple quantum wells in 1.55-µm range", APPLIED PHYSICS LETTERS, A I P PUB-LISHING LLC, US, Bd. 82, Nr. 11, 17. März 2003;
- GUEZO M ET AL: "Nonlinear absorption temporal dynamics of Fe-doped GalnAs/lnP multiple quantum wells", JOURNAL OF APPLIED PHYSICS, AMERICAN INSTITUTE OF PHYSICS, US, Bd. 94, Nr. 4, 15. August 2003 (2003-08-15).

Das der Erfindung zugrunde liegende Problem besteht darin, eine Terahertz-Antenne mit möglichst guten Terahertzeigenschaften zu schaffen.

Dieses Problem wird durch die Bereitstellung einer Terahertz-Antenne mit den Merkmalen des Anspruchs 1 sowie durch das Verfahren mit den Merkmalen des Anspruchs 12 gelöst.

Danach wird eine Terahertz-Antenne bereitgestellt, mit
- mindestens einer fotoleitenden Schicht (in Form einer epitaktischen Halbleiterschicht), die bei Einstrahlung von Licht Ladungsträger generiert;
- zwei elektrisch leitfähige Antennenelemente, über die ein elektrisches Feld an zumindest einen Abschnitt der fotoleitenden Schicht anlegbar ist,
- die fotoleitenden Schicht mit einem Dotierstoff in einer Konzentration von mindestens 1 x 10¹⁹cm⁻³ dotiert ist, wobei es sich bei dem Dotierstoff um ein Übergangsmetall handelt, und wobei
- die fotoleitende Schicht per Molekularstrahlepitaxie (MBE) bei einer Wachstumstemperatur (Substrattemperatur während der Epitaxie) von mindestens 200° C und maximal 500° C (z.B. bei einer Wachstumstemperatur zwischen 250°C oder 300° C und 500 ° C) erzeugt ist, wobei der Dotierstoff so in der fotoleitenden Schicht angeordnet ist, dass er eine Vielzahl von Punktdefekten erzeugt.

Im Wesentlichen sind sämtliche Dotierstoffatome - unter Vermeidung von Dotierstoff-Clustern -jeweils in Form eines Punktdefekts in der fotoleitenden Schicht angeordnet.

Die fotoleitende Schicht der erfindungsgemäßen Terahertz-Antenne weist somit insbesondere keine oder nur eine geringe Anzahl von Dotierstoffclustern auf, da sie bei einer relativ niedrigen Temperatur (insbesondere im Vergleich mit dem MOVPE-Verfahren) gewachsen ist. Die niedrige Wachstumstemperatur wirkt einer Diffusion des Dotierstoffs und damit der Clusterbildung entgegen. Die Vermeidung oder Reduzierung der Clusterbildung ermöglicht die hohe Dotierung der fotoleitenden Schicht. Beispielsweise kann die Dotierstoffkonzentration sogar mindestens 1 ×10²⁰cm⁻³ betragen, wobei - wenn im Wesentlichen jedes Dotierstoffatom als Punktdefekt in die fotoleitende Schicht eingebaut ist - die Dotierstoffkonzentration im Wesentlichen der Konzentration der Punktdefekte der fotoleitenden Schicht entspricht.

Der Dotierstoff ist somit so in der fotoleitenden Schicht angeordnet, dass er eine Vielzahl von Punktdefekten und damit Rekombinationszentren erzeugt. Eine untere Grenze der Wachstumstemperatur liegt wie erwähnt bei 200° C, 250°C oder 300°C, um eine verstärkte Ausbildung von Kristalldefekten möglichst zu vermeiden. Die fotoleitende Schicht kann somit eine möglichst gute Kristallqualität bei hoher Dotierung aufweisen, so dass sie einen möglichst hohen Dunkelwiderstand besitzt und sehr kurze Rekombinationszeiten sowie eine hohe Beweglichkeit der erzeugten Fotoladungsträger ermöglicht.

Des Weiteren ist die fotoleitende Schicht insbesondere so ausgebildet, dass sie bei Einstrahlung von Licht im Wellenlängenbereich zwischen 1000 und 1650 nm Ladungsträger erzeugt. Beispielsweise ist die fotoleitende Schicht für die Erzeugung von Ladungsträgern bei Anregung mit Strahlung im Wellenlängenbereich 1400 - 1650 nm oder 1000 - 1600 nm ausgebildet (insbesondere optimiert). Beispielsweise besteht die mindestens eine fotoleitende Schicht aus (In, Ga)As, (In, Ga)(As, P) oder (In, Ga, AI)(As, P), insbesondere aus InGaAs, InGaAsP oder InAIAs. Denkbar ist auch, dass mehrere fotoleitende Schichten vorhanden sind und/oder die fotoleitende Schicht Teil eines Schichtpaketes ist (das z.B. neben der mindestens einen fotoleitenden Schicht weitere, nicht zwingend fotoleitende Schichten, z.B. eine Bufferschicht, umfasst). Als Substratmaterial kommt insbesondere Indiumphosphid oder Galliumarsenid in Frage (z.B. semiisolierend).

Die fotoleitende Schicht weist zudem insbesondere eine Dicke von mindestens 100 nm, mindestens 300 nm oder mindestens 500 nm auf.

Bei dem Dotierstoff, mit dem die fotoleitende Schicht dotiert ist, handelt es sich beispielsweise um ein Übergangsmetall, z.B. Eisen, Chrom, Ruthenium, Rhodium und/oder Iridium.

Die Antennenelemente der erfindungsgemäßen Terahertz-Antenne bilden insbesondere eine Bow-Tie-, eine Dipol-Tie- oder eine Strip-Line-Struktur aus.

Denkbar ist auch, dass die fotoleitende Schicht eine Mesa-Struktur ausformt, wobei die Antennenelemente jeweils mit einer Seitenwand (die sich jeweils senkrecht zum Substrat erstreckt) der Mesa-Struktur verbunden sind.

Möglich ist auch, dass die Beleuchtung der fotoleitenden Schicht über mindestens einen (insbesondere integrierten) Wellenleiter erfolgt; z.B. wird das Licht über den Wellenleiter seitlich (über eine Stirnseite der fotoleitenden Schicht) in die fotoleitende Schicht eingekoppelt. Darüber hinaus kann die fotoleitende Schicht einen beleuchtbaren Bereich aufweisen, der über Vorsprünge ("Finger") mit den Antennenelementen verbunden ist.

Die erfindungsgemäße Terahertz-Antenne kann z.B. als Terahertz-Sender und/oder als kohärenter Terahertz-Empfänger (oder als Bestandteil eines Terahertz-Senders und/oder als eines Terahertz-Empfängers) sowohl in Terahertz-Pulssystem (Licht wird in Form von optischen Pulse auf die fotoleitende Schicht eingestrahlt) als auch in Terahertz-Dauerstrichsystemen (cw-Systemen) eingesetzt werden; d.h. in Systemen, bei denen moduliertes cw-Licht auf die fotoleitende Schicht eingestrahlt wird.

Entsprechend betrifft die Erfindung auch einen Terahertz-Wandler zum Erzeugen und/oder Empfangen von Terahertz-Strahlung, wobei der Terahertz-Wandler mindestens eine Terahertz-Antenne nach einem der vorherstehend beschriebenen Ausführungsbeispiele aufweist.

Beispielsweise umfasst der Terahertz-Wandler eine erste und eine zweite Terahertz-Antenne, die jeweils nach einem der vorherstehend beschriebenen Ausführungsbeispiele ausgebildet sind, wobei die fotoleitenden Schichten der ersten und der zweiten Terahertz-Antenne Abschnitte einer gemeinsamen fotoleitenden Schicht sind. Mit anderen Worten weist dieser Terahertz-Wandler ein erstes Antennenpaar (Sendeantennenpaar) auf, das zusammen mit einem zweiten Antennenpaar (Empfängerantennenpaar) auf einer gemeinsamen fotoleitenden Schicht oder einem gemeinsamen fotoleitenden Schichtpaket angeordnet (d.h. monolithisch integriert) sind.

Die Erfindung betrifft des Weiteren ein Verfahren zum Herstellen einer Terahertz-Antenne, insbesondere wie vorstehend beschrieben, mit den Schritten:
- Erzeugen mindestens einer fotoleitenden Schicht, die bei Einstrahlung von Licht Ladungsträger generiert, wobei
- Dotieren der fotoleitenden Schicht mit einem Dotierstoff in einer Konzentration von mindestens 1 x 10⁹cm⁻³, wobei es sich bei dem Dotierstoff um ein Übergangsmetall handelt; und
- Erzeugen zweier elektrisch leitfähiger Antennenelemente, über die eine elektrische Spannung an zumindest einen Abschnitt der fotoleitenden Schicht anlegbar ist, wobei
- die fotoleitende Schicht per Molekularstrahlepitaxie bei einer Wachstumstemperatur von mindestens 200° C und maximal 500° C erzeugt wird und das Dotieren während des Epitaxievorganges erfolgt.

Das Wachsen der fotoleitenden Schicht erfolgt also wie oben bereits erwähnt bei relativ niedrigen Temperaturen. Insbesondere liegt die Wachstumstemperatur deutlich niedriger als bei der MOVPE, bei der chemische Reaktionen auf der Substratoberfläche ermöglicht werden müssen, was höhere Temperaturen z.B. im Bereich von 600° C erfordert.

Beispielsweise liegt die Wachstumstemperatur zwischen 250° C oder 300° C und 500° C. In einem Ausführungsbeispiel des erfindungsgemäßen Verfahrens beträgt die Substrattemperatur während des Epitaxievorganges höchstens 450° C oder höchstens 400° C. Denkbar ist auch, dass nach dem Aufwachsen der fotoleitenden Schicht ein Temperschritt durchgeführt wird, insbesondere in Form eines Ausheilschritts. Beispielsweise wird die fotoleitende Schicht während des Temperschritts einer im Vergleich zur Wachstumstemperatur höheren Temperatur ausgesetzt. Denkbar ist zudem, dass sich die fotoleitende Schicht während des Temperschritts in einer stabilisierenden Atmosphäre befindet. Möglich ist auch, dass der Temperschritt unmittelbar nach Abschluss des Wachsens der fotoleitenden Schicht (oder der mehreren fotoleitenden Schichten) erfolgt, wobei insbesondere ein Kontakt der fotoleitenden Schicht mit Luft vermieden wird. Insbesondere wird der Temperschritts in der zum Wachsen der fotoleitenden Schicht verwendeten MBE-Anlage durchgeführt.

Die weiter oben in Bezug auf die erfindungsgemäße Terahertz-Antenne beschriebenen Ausführungsformen können natürlich entsprechend zur Weiterbildung des erfindungsgemäßen Verfahrens dienen. Beispielsweise wird die fotoleitende Schicht mit einer Dicke von mindestens 100 nm, mindestens 300 nm oder mindestens 500 nm gewachsen.

Die Erfindung wird im Folgenden anhand von Ausführungsbeispielen unter Bezugnahme auf die Figuren näher erläutert. Es zeigen:
- Figur 1: schematisch ein Banddiagramm einer auf einem IndiumphosphidSubstrat gewachsenen fotoleitenden InGaAs-Schicht; und
- Figur 2: eine Draufsicht auf eine Terahertz-Antenne gemäß einem Ausführungsbeispiel der Erfindung.

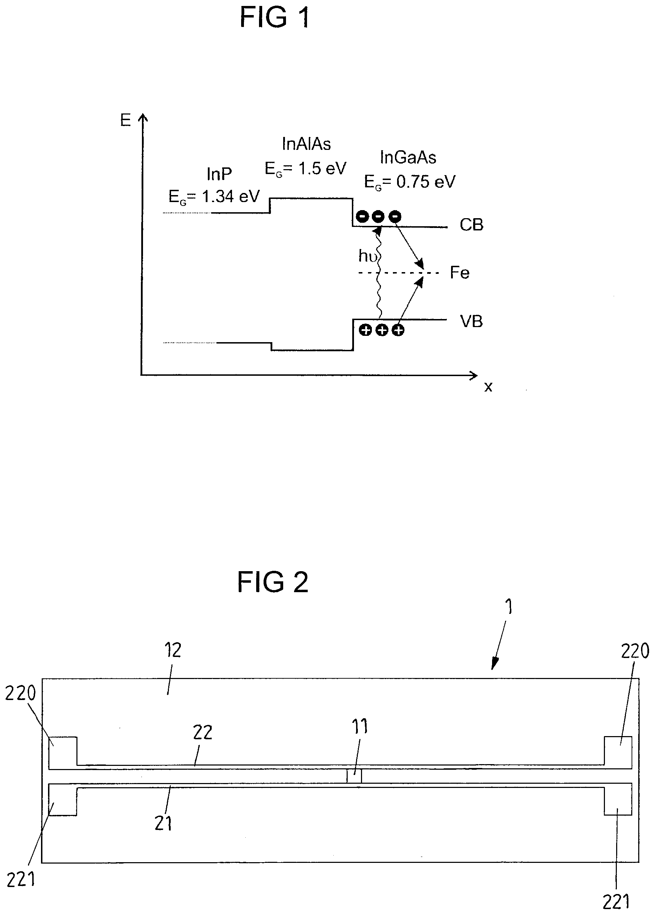

Das in Fig. 1 dargestellte Banddiagramm bezieht auf eine mögliche Konfiguration der fotoleitenden Schicht der erfindungsgemäßen Terahertz-Antenne. Die fotoleitende Schicht ist hier in Form einer InGaAs-Schicht ausgebildet, die gitterangepasst auf einem InP-Substrat aufgewachsen wurde. Zwischen der InGaAs-Schicht und dem InP-Substrat befindet sich eine InAIAs-Bufferschicht. In dem Diagramm sind die jeweiligen Bandabstände angegeben (CB: Leitungsband; VB: Valenzband).

In der Mitte der Bandlücke der InGaAs-Schicht befindet sich das Energieniveau (gestrichelte Linie) punktartiger Rekombinationszentren, die durch Dotierung der InGaAs-Schicht mit einem Übergangsmetall (z.B. Fe) erzeugt wurden.

Trifft Licht ("hν"), z.B. in Form eines Laserpulses mit einer Mittenwellenlänge von 1550 nm, auf die InGaAs-Schicht auf, werden dort Elektronen aus dem Valenzband VB in das Leitungsband CB angeregt und entsprechend Elektron-Loch-Paare erzeugt.

Die angeregten Elektronen werden durch eine an die InGaAs-Schicht angelegte Spannung beschleunigt, wobei die beschleunigten Elektronen Terahertz-Strahlung abgeben. Die erzeugten Elektron-Loch-Paare rekombinieren in den Rekombinationszentren, wobei die Rekombinationszeit aufgrund der durch die Dotierung erzeugten punktartigen Rekombinationszentren sehr kurz ist. Die InAIAs-Bufferschicht und das Substrat sind an der Erzeugung der Elektron-Loch-Paare aufgrund ihres größeren Bandabstandes nicht beteiligt.

Figur 2 zeigt eine Draufsicht auf eine erfindungsgemäße Terahertz-Antenne 1. Die Terahertz-Antenne 1 weist eine per MBE auf einem Substrat 12 (z.B. ein semiisolierendes InP-Substrat) erzeugte fotoleitende Halbleiterschicht 11 auf, die eine quaderartige Mesa-Struktur ausbildet. Darüber hinaus weist die fotoleitende Halbleiterschicht 11 eine höhere Konzentration (mindestens 1 ×10¹⁸cm⁻³) eines Dotierstoffs (z.B. Eisen) auf. Denkbar ist, dass die fotoleitende Halbleiterschicht 11 aus dotiertem InGaAs ausgebildet ist oder ein derartiges Material aufweist.

Darüber hinaus besitzt die Terahertz-Antenne 1 ein erstes und ein zweites streifenartiges Antennenelement21, 22, das jeweils auf dem Substrat 12 angeordnet ist. Die Antennenelemente 21, 22 sind aus einem Metall ausgebildet und wurden auf dem Substrat 12 abgeschieden (z.B. aufgedampft).

Des Weiteren sind die parallel zueinander verlaufenden Antennenelemente 21, 22 jeweils mit einer Seite der fotoleitenden Halbleiterschicht 11 elektrisch verbunden, so dass über die Antennenelemente 21, 22 eine Spannung an die Halbleiterschicht 11 angelegt werden kann. Zum Anschluss einer Spannungsquelle weisen die Antennenelemente 21, 22 jeweils Kontaktflächen 210, 220 auf.

## Patentansprüche

1. Terahertz-Antenne, mit
- mindestens einer fotoleitenden Schicht (11), die bei Einstrahlung von Licht Ladungsträger generiert;
- zwei elektrisch leitfähige Antennenelemente (21, 22), über die ein elektrisches Feld an zumindest einen Abschnitt der fotoleitenden Schicht (11) anlegbar ist,
- die fotoleitenden Schicht (11) mit einem Dotierstoff dotiert ist, wobei es sich bei dem Dotierstoff um ein Übergangsmetall handelt,
wobei die fotoleitende Schicht (11) per Molekularstrahlepitaxie bei einer Wachstumstemperatur von mindestens 200° C und maximal 500° C erzeugt ist, wobei der Dotierstoff so in der fotoleitenden Schicht (11) angeordnet ist, dass er eine Vielzahl von Punktdefekten erzeugt, wobei im Wesentlichen sämtliche Dotierstoffatome jeweils in Form eines Punktdefekts in der fotoleitenden Schicht (11) angeordnet sind, wobei die Konzentration des Dotierstoffs mindestens 1 × 10¹⁹ cm-³ beträgt.

2. Terahertz-Antenne nach Anspruch 1, **dadurch gekennzeichnet, dass** die fotoleitenden Schicht (11) keine Dotierstoffcluster aufweist.

3. Terahertz-Antenne nach einem der vorhergehenden Ansprüche, **dadurch gekennzeichnet, dass** die Konzentration des Dotierstoffs mindestens 1 ×10²⁰cm⁻³ beträgt.

4. Terahertz-Antenne nach einem der vorhergehenden Ansprüche, **dadurch gekennzeichnet, dass** die fotoleitende Schicht (11) so ausgebildet ist, dass sie bei Einstrahlung von Licht im Wellenlängenbereich zwischen 1000 und 1650 nm Ladungsträger erzeugt.

5. Terahertz-Antenne nach einem der vorhergehenden Ansprüche, **dadurch gekennzeichnet, dass** die fotoleitende Schicht (11) aus [In, Ga]As, [In, Ga][As, P] oder [In, Ga, AI][As, P] ausgebildet ist.

6. Terahertz-Antenne nach einem der vorhergehenden Ansprüche, **dadurch gekennzeichnet, dass** die fotoleitende Schicht (11) eine Dicke von mindestens 100 nm, mindestens 300 nm oder mindestens 500 nm aufweist.

7. Terahertz-Antenne nach einem der vorhergehenden Ansprüche, **dadurch gekennzeichnet, dass** die fotoleitende Schicht (11) auf einem semiisolierenden Substrat (12) aufgewachsen ist.

8. Terahertz-Antenne nach einem der vorhergehenden Ansprüche, **dadurch gekennzeichnet, dass** es sich bei dem Dotierstoff um Eisen, Ruthenium, Rhodium und/oder Iridium handelt.

9. Terahertz-Antenne nach einem der vorhergehenden Ansprüche, **dadurch gekennzeichnet, dass** die fotoleitende Schicht (11) eine Mesa-Struktur ausbildet, wobei die Antennenelemente (21, 22) jeweils mit einer Seitenwand der Mesa-Struktur verbunden sind.

10. Terahertz-Wandler zum Erzeugen und/oder Empfangen von Terahertz-Strahlung, wobei der Terahertz-Wandler mindestens eine Terahertz-Antenne (1) nach einem der vorhergehenden Ansprüche aufweist.

11. Terahertz-Wandler nach Anspruch 10, **gekennzeichnet durch** eine erste und eine zweite Terahertz-Antenne, die jeweils nach einem der vorhergehenden Ansprüche ausgebildet sind, wobei die fotoleitenden Schichten der ersten und der zweiten Terahertz-Antenne Abschnitte einer gemeinsamen fotoleitenden Schicht sind.

12. Verfahren zum Herstellen einer Terahertz-Antenne, insbesondere nach einem der vorhergehenden Ansprüche, mit den Schritten:
- Erzeugen mindestens einer fotoleitenden Schicht (11), die bei Einstrahlung von Licht Ladungsträger generiert;
- Dotieren der fotoleitenden Schicht (11) mit einem Dotierstoff, wobei es sich bei dem Dotierstoff um ein Übergangsmetall handelt; und
- Erzeugen zweier elektrisch leitfähiger Antennenelemente (21, 22), über die eine elektrische Spannung an zumindest einen Abschnitt der fotoleitenden Schicht (11) anlegbar ist,
wobei die fotoleitende Schicht (11) per Molekularstrahlepitaxie bei einer Wachstumstemperatur von mindestens 200° C und maximal 500° C erzeugt wird und das Dotieren während des Epitaxievorganges erfolgt, wobei die Konzentration des Dotierstoffs mindestens 1 × 10¹⁹ cm⁻³ beträgt.

13. Verfahren nach Anspruch 12, **dadurch gekennzeichnet, dass** die Wachstumstemperatur zwischen 250°C oder 300° C und 500° C liegt, wobei die Wachstumstemperatur insbesondere höchstens 450° C oder höchstens 400° C beträgt.

14. Verfahren nach Anspruch 12 oder 13, **dadurch gekennzeichnet, dass** nach dem Aufwachsen der fotoleitenden Schicht (11) ein Temperschritt durchgeführt wird.

## Claims

1. A terahertz antenna, comprising
- at least one photoconductive layer (11) which generates charge carriers upon irradiation of light;
- two electroconductive antenna elements (21, 22) via which an electric field can be applied to at least one section of the photoconductive layer (11),
- the photoconductive layer (11) being doped with a dopant, wherein the dopant is a transition metal,
wherein the photoconductive layer (11) is generated by molecular beam epitaxy at a growth temperature of at least 200 °C and not more than 500 °C, wherein the dopant is arranged in the photoconductive layer (11) in such a way that it generates a multitude of point defects, wherein substantially all dopant atoms each are arranged in the photoconductive layer (11) in the form of a point defect, wherein the concentration of the dopant is at least 1 × 10¹⁹ cm⁻³.

2. The terahertz antenna according to claim 1, **characterized in that** the photoconductive layer (11) does not include any dopant clusters.

3. The terahertz antenna according to any of the preceding claims, **characterized in that** the concentration of the dopant is at least 1 × 10²⁰ cm⁻³.

4. The terahertz antenna according to any of the preceding claims, **characterized in that** the photoconductive layer (11) is configured such that it generates charge carriers upon irradiation of light in a wavelength range between 1000 and 1650 nm.

5. The terahertz antenna according to any of the preceding claims, **characterized in that** the photoconductive layer (11) is formed of [In, Ga]As, [In, Ga][As, P] or [In, Ga, AI][As, P].

6. The terahertz antenna according to any of the preceding claims, **characterized in that** the photoconductive layer (11) has a thickness of at least 100 nm, at least 300 nm or at least 500 nm.

7. The terahertz antenna according to any of the preceding claims, **characterized in that** the photoconductive layer (11) is grown on a semi-insulating substrate (12).

8. The terahertz antenna according to any of the preceding claims, **characterized in that** the dopant is iron, ruthenium, rhodium and/or iridium.

9. The terahertz antenna according to any of the preceding claims, **characterized in that** the photoconductive layer (11) forms a mesa structure, wherein the antenna elements (21, 22) each are connected to a side wall of the mesa structure.

10. A terahertz converter for generating and/or receiving terahertz radiation, wherein the terahertz converter includes at least one terahertz antenna (1) according to any of the preceding claims.

11. The terahertz converter according to claim 10, **characterized by** a first and a second terahertz antenna, which each are configured according to any of the preceding claims, wherein the photoconductive layers of the first and the second terahertz antenna are sections of a common photoconductive layer.

12. A method for producing a terahertz antenna, in particular according to any of the preceding claims, comprising the following steps:
- producing at least one photoconductive layer (11) which generates charge carriers upon irradiation of light;
- doping of the photoconductive layer (11) with a dopant, wherein the dopant is a transition metal; and
- producing two electrically conductive antenna elements (21, 22), via which an electric voltage can be applied to at least one section of the photoconductive layer (11),
wherein the photoconductive layer (11) is generated by molecular beam epitaxy at a growth temperature of at least 200 °C and not more than 500 °C, and doping is effected during the process of epitaxy, wherein the concentration of the dopant is at least 1 × 10¹⁹ cm⁻³.

13. The method according to claim 12, **characterized in that** the growth temperature lies between 250 °C or 300 °C and 500 °C, wherein the growth temperature in particular is not more than 450 °C or not more than 400 °C.

14. The method according to claim 12 or 13, **characterized in that** after growing the photoconductive layer (11) a tempering step is performed.

## Revendications

1. Antenne térahertz, comportant
- au moins une couche photoconductrice (11), qui génère des porteurs de charge lors de l'irradiation par la lumière ;
- deux éléments d'antenne conducteurs d'électricité (21, 22) par lesquels un champ électrique peut être appliqué à au moins une partie de la couche photoconductrice (11), la couche photoconductrice (11) est dopée avec un dopant, le dopant étant un métal de transition ;
dans laquelle la couche photoconductrice (11) est produite par épitaxie par jet moléculaire à une température de croissance d'au moins 200°C et de 500°C au maximum, le dopant étant placé dans la couche photoconductrice (11) de telle sorte qu'il produit une pluralité de défauts ponctuels, dont essentiellement tous les atomes dopants sont disposés dans la couche photoconductrice (11) sous forme de défauts ponctuels, la concentration du dopant étant d'au moins 1 × 10¹⁹ cm⁻³.

2. Antenne térahertz selon la revendication 1, **caractérisée en ce que** la couche photoconductrice (11) ne comporte pas d'amas de dopants.

3. Antenne térahertz selon l'une quelconque des revendications précédentes, **caractérisée en ce que** la concentration du dopant est au moins 1 × 10²⁰ cm⁻³.

4. Antenne térahertz selon l'une quelconque des revendications précédentes, **caractérisée en ce que** la couche photoconductrice (11) est conçue de telle sorte qu'elle génère des porteurs de charge lors de l'irradiation par la lumière dans la plage de longueur d'onde comprise entre 1000 et 1650 nm.

5. Antenne térahertz selon l'une quelconque des revendications précédentes, **caractérisée en ce que** la couche photoconductrice (11) est formé de [In, GA]As, [In, Ga][As, P] ou [In, Ga, AI][As, P].

6. Antenne térahertz selon l'une quelconque des revendications précédentes, **caractérisée en ce que** la couche photoconductrice (11) présente une épaisseur d'au moins 100 mm, d'au moins 300 nm ou d'au moins 500 nm.

7. Antenne térahertz selon l'une quelconque des revendications précédentes, **caractérisée en ce que** la couche photoconductrice (11) est faite croître sur un substrat semi-isolant (12).

8. Antenne térahertz selon l'une quelconque des revendications précédentes, **caractérisée en ce que** le dopant est le fer, le ruthénium, le rhodium et/ou l'iridium.

9. Antenne térahertz selon l'une quelconque des revendications précédentes, **caractérisée en ce que** la couche photoconductrice (11) forme une structure mésa, les éléments d'antenne (21, 22) étant chacun reliés à une paroi latérale de la structure mésa.

10. Convertisseur térahertz pour la génération et/ou la réception de rayonnement térahertz, dans lequel le convertisseur térahertz présente au moins une antenne térahertz (1) selon l'une quelconque des revendications précédentes.

11. Convertisseur térahertz selon la revendication 10, **caractérisé par** une première et une deuxième antenne térahertz, chacune conçue selon l'une quelconque des revendications précédentes, les couches photoconductrices de la première et de la deuxième antenne térahertz étant des parties d'une couche photoconductrice commune.

12. Procédé de fabrication d'une antenne térahertz, en particulier selon l'une quelconque des revendications précédentes, comportant les étapes suivantes :
- la production d'au moins une couche photoconductrice (11) qui génère des porteurs de charge lors de l'irradiation par la lumière ;
- le dopage de la couche photoconductrice (11) avec un dopant, le dopant étant un métal de transition ; et
- la production de deux éléments d'antenne conducteurs d'électricité (21, 22) par lesquels une tension électrique peut être appliquée à au moins une partie de la couche photoconductrice (11),
dans lequel la couche photoconductrice (11) est produite par épitaxie par jet moléculaire à une température de croissance d'au moins 200°C et de 500°C au maximum, et le dopage est effectué durant le processus d'épitaxie, la concentration du dopant étant d'au moins 1 × 10¹⁹ cm⁻³.

13. Procédé selon la revendication 12, **caractérisé en ce que** la température de croissance est comprise entre 250°C ou 300°C et 500°C, la température de croissance étant en particulier 450°C au maximum ou 400°C au maximum.

14. Procédé selon la revendication 12 ou 13, **caractérisé en ce qu'**une étape de recuit est effectuée après la croissance de la couche photoconductrice (11).
